# EUROPEAN PATENT APPLICATION

(11) **EP 1 158 706 A1**
(43) Date of publication of application: **28.11.2001**
(21) Application number: 00111110.3
(22) Date of filing: 23.05.2000
(51) Int. Cl.: H04H 1/00

(54) **RDS decoder for reducing the influence of noise peaks using a noise blanker**

(71) Applicant: Sony International (Europe) GmbH, 10785 Berlin (DE)
(72) Inventor: Wildhagen, Jens, Advanced Tech. Cent. Stuttgart, 70327 Stuttgart (DE)
(74) Representative: Müller . Hoffmann & Partner Patentanwälte

(57) **Abstract**

A RDS decoder with at least one recovery loop to recover signal parts of or relations within a received RDS signal which are needed for the decoding process comprises a noise blanker (4) within said at least one recovery loop preventing the unlocking of the respective recovery loop by eliminating the influence of a noise peak to the recovery process.

## Description

The present invention relates to a RDS decoder, in particular to a RDS decoder comprising at least one recovery loop to recover signal parts of or relations within a received RDS signal which are needed for the decoding process, and a method to decode a RDS signal.

RDS decoders are highly interference-prone, in particular a RDS decoder can loose synchronization if a noise peak or another comparable distortion occurs, since a noise peak or e. g. neighbor channel distortions contain significant energy in the band of the RDS signal.

Noise blankers for the audio signal arranged within FM broadcast receivers are known to achieve an enhancement of the signal quality. These techniques use the fact that pulse distortions, for example from an ignition in a car, and neighbour channel distortions have a very broad spectrum and, on the other hand, the stereo multiplex signal contains signal energy only in the frequency band below 60 kHz. Therefore, the pulse distortions can be detected by a highpass filtering of the frequency demodulated stereo-multiplex signal, i. e. the noise peaks can be detected by analyzing out of band distortions. A further method for deriving a quality signal dependent on the quality of a received multiplex signal in a stereo broadcast receiver to be used to blank the audio signal is disclosed in EP 0 691 049 B1.

In case a distortion is detected the audio output signal is hold by a sample and hold unit to blank the noise peak. Such a circuit for removing ignition noise from a multiplexed signal is disclosed in US 5,535,280.

However, due to probable information loss this technique of blanking the noise peak by sampling and holding the audio signal is not applicable for RDS demodulation/decoding.

GB 2 235 610 A describes to generate a stable internal clock signal which is based on a demodulated clock signal to achieve a disturbance-free RDS decoding. However, such a correction of the demodulated RDS clock signal to become a more accurate internal clock signal to be used to decode the RDS data requires a quite complicated circuitry which produces the internal clock signal based on a duty ratio of the demodulated RDS clock signal. The duty ration of the demodulated clock signal is analyzed by a so-called SREGEN duty ratio control circuit.

Therefore, it is the object underlying the present invention to decrease the error rate of a RDS decoder without using complicated circuitry, such as an additional internal clock generation circuit.

This object is achieved with a RDS decoder according to independent claim 1 and a method to decode a RDS signal according to independent claim 9. The respectively following dependent claims define respective preferred embodiments thereof.

According to the present invention a noise blanker is inserted into at least one recovery loop of the RDS decoder which prevents the unlocking of the respective recovery loop by eliminating the influence of a noise peak to the recovery process.

Therewith, according to the present invention not the disturbed signal is blanked by sampling and holding parts of the undisturbed signal appearing just before the distortion, but the influence of the distortion to a recovery process gets blanked. Therewith, the distortion itself remains within the decoded signal, but the respective recovery loop does not loose synchronization which prevents an erroneous decoding directly after the distortion which would occur due to a new synchronization procedure.

Preferably, the output signal of a phase detector within a carrier recovery loop of the RDS decoder is blanked during the noise peak and/or the time error detected within a time recovery loop of the RDS decoder is blanked during the noise peak. Therefore, these signals are preferably set to zero.

Noise peaks which influence is eliminated according to the present invention might be detected according to any method known in the prior art, in particular preferably a noise peak is detected by a threshold function within the respective recovery loop according to which output signals of the loop detector which exceed a predetermined threshold are set to zero. Furthermore, alternatively or additionally noise peaks might also be detected by a noise peak detector of an audio noise blanker included in the receiver which hosts the RDS decoder and/or based on the noise in the in-quadrature component of a stereo-difference signal within a reception signal including the RDS signal.

The present invention will be better understood from the following description of an exemplary embodiment thereof taken in conjunction with the accompanying figures, wherein
- **Fig. 1**: shows a baseband COSTAS loop for the recovery of the RDS carrier according to the present invention;
- **Fig. 2**: shows a frequency modulation broadcast receiver with RDS decoder;
- **Fig. 3**: shows a coherent amplitude demodulated RDS data signal, i. e. the output signal of the COSTAS loop shown in Fig. 1;
- **Fig. 4**: shows the output signal of the COSTAS carrier recovery loop shown in Fig. 1, i. e. with noise blanker in the feedback loop; and
- **Fig. 5**: shows the output signal of a COSTAS loop according to the prior art, i. e. without noise blanker in the feedback loop.

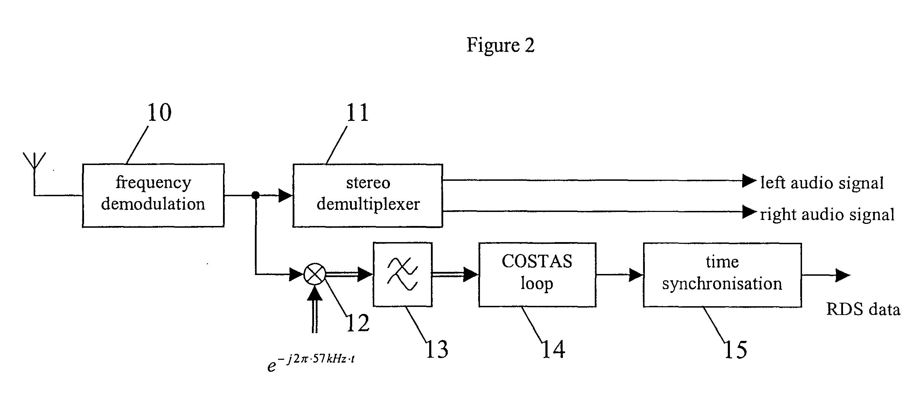

Fig. 2 shows the general structure of a frequency modulation broadcast receiver. The received signal undergoes a frequency demodulation 10 before a stereo-demultiplexer 11 generates left and right audio signals from the frequency demodulated multiplex signal. Furthermore, from the frequency demodulated multiplex signal the DSB (double sideband) modulated RDS signal is downconverted to a complex baseband signal by a mixer 12 multiplying the frequency demodulated multiplex signal by e^{-j2π·57kHz·t} and a following lowpass filtering 13. The complex RDS baseband signal is input to a COSTAS carrier recovery loop 14 which output signal is the coherent demodulated RDS signal. This RDS signal is decoded in a time synchronization stage 15 which outputs the RDS data. According to "Principles of Communication" from Ziemer, Trauter, ISBN 0-471-12496-6 the generation of the complex baseband signal 12 and the following lowpass filtering 13 can be included in the COSTAS loop 14.

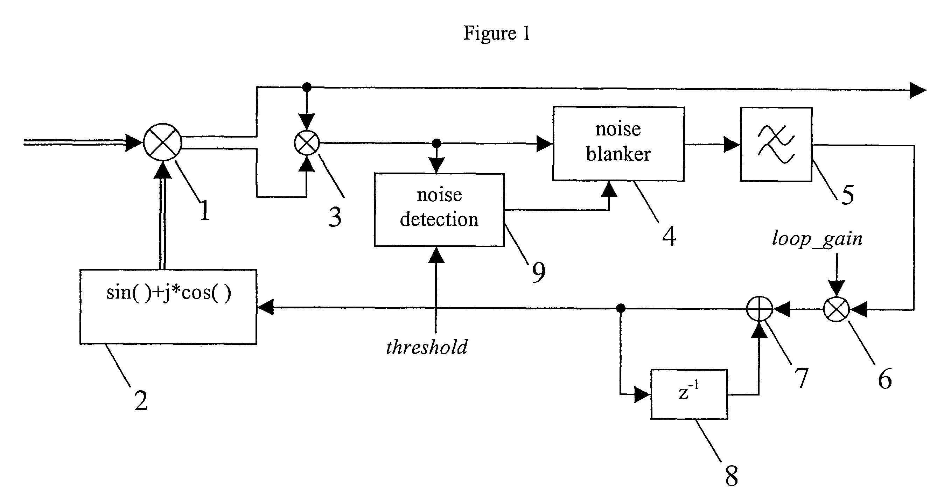

Fig. 1 shows a baseband COSTAS loop for the coherent amplitude demodulation of the DSB modulated RDS signal according to the present invention.

The complex RDS baseband signal is supplied to a complex mixer 1 which outputs the inphase and the inquadrature component of the DSB modulated RDS signal. These both signals are supplied to a phase-detector 3 detecting the phase error of the coherent amplitude demodulated RDS data signal. The output signal of the phase-detector 3 is input to a noise blanker 4 which supplies its output signal to a lowpass filter 5. The lowpass filtered output signal of the noise blanker 4 is supplied to a multiplier 6 which sets the loop gain of the COSTAS loop by multiplication with a constant factor COSTAS_loop_gain. This adjusted signal is input to an adder 7 which adds its one sample delayed output signal thereto. This one sample delayed output signal of the adder 7 is obtained via a delay element 8. The adder 7 and the delay element 8 realize an integrator. The output signal of this integrator, i. e. of the adder 7, is also input to a complex oscillator 2 providing a complex frequency signal dependent on the supplied phase signal to the complex mixer 1.

The noise blanker 4 according to the present invention is supplied with a control signal which indicates noise peaks or other distortions which should be blanked. Every time a noise peak or another distortion which should be blanked is detected the noise blanker 4 sets the output signal of the phase detector 3 to zero. Otherwise, this output signal of the phase detector 3 is input to the lowpass filter 5 via the noise blanker 4. The control signal can be obtained for example by comparing the amplitude of the output signal of phase detector 3 with a threshold. If a noise detector 9 detects that the amplitude of the phase detector output signal exceeds the threshold the control signal supplied by the noise detector 9 indicates to the noise blanker 4 to set the phase detector output signal to zero.

As mentioned above, the noise peak detection can be realized as a simple treshold function or additionally or alternatively it can be based on the output of the noise detector included in the audio noise blanker circuit which might work based on a detection of out of band distortions. Furthermore, the noise in the in-quadrature component of the stereo-difference signal might alternatively or additionally be detected. To increase the detection rate of noise or noise peaks a combination of all detection mechanisms or a subset thereof is possible ass well as the combination thereof with other known noise detection mechanisms.

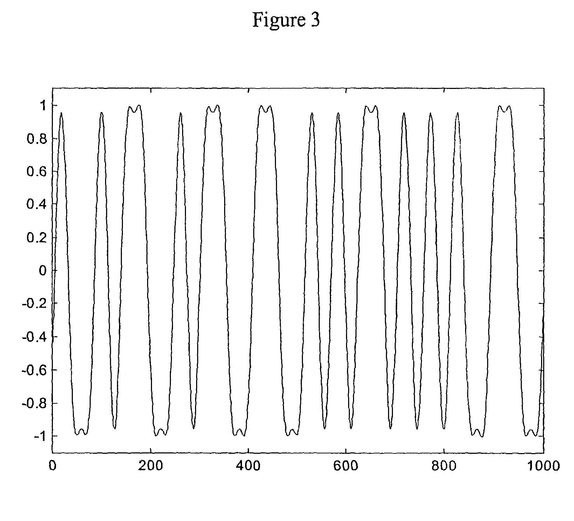

Fig. 3 shows a coherent amplitude demodulated RDS data signal, i. e. the output signal of the COSTAS loop, which is filtered with a matched filter for optimal RDS decoding in front of the RDS decoder. It is clearly to be seen that the output signal is a more or less regularly oscillating signal.

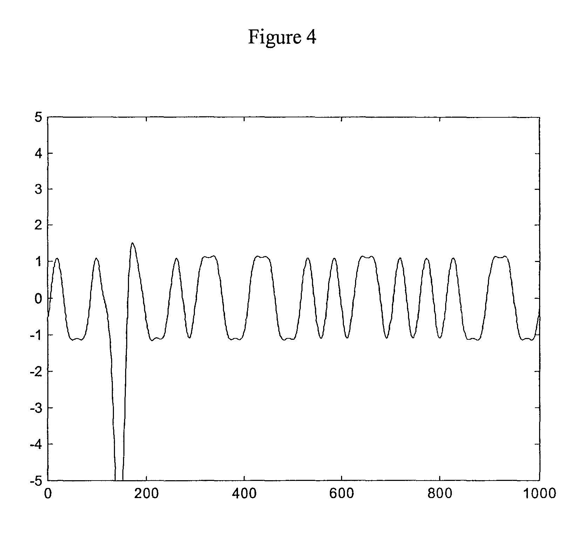

Fig. 4 shows the output signal of the COSTAS carrier recovery loop according to the present invention, i. e. with noise blanker 4 inserted into the feedback loop. It can be seen that the COSTAS loop output signal contains no distortions except one distortion produced by the noise peak itself, which means that the loop does not lose synchronization.

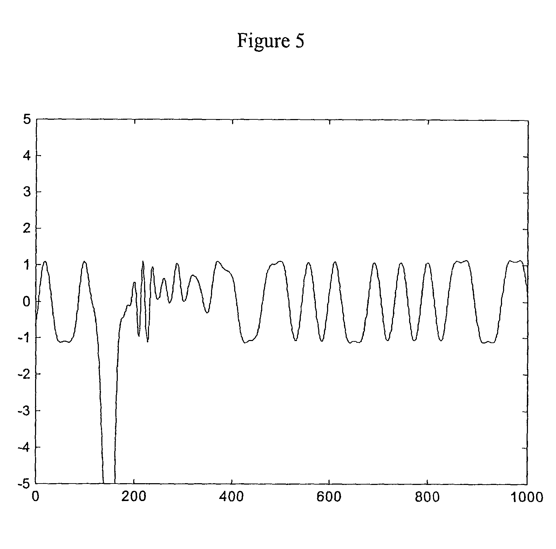

On the other hand, Fig. 5 shows the output signal of a COSTAS loop without noise blanker which comprises heavy distortions after the noise peak, i. e. which indicates that the COSTAS loop needed some time to resynchronize.

According to the present invention the same noise blanker can be included in the RDS time recovery loop. In case a noise peak occurs the time error is set to 0.

Preferably, in case a noise peak occurs the output signal of the phase detector of the COSTAS carrier recovery loop and the RDS time synchronization loop are reset to 0 so that the noise peak will not unlock the RDS carrier and time recovery loops.

## Claims

1. RDS decoder, comprising at least one recovery loop to recover signal parts of or relations within a received RDS signal which are needed for the decoding and/or demodulation process, **characterized by** a noise blanker (4) within said at least one recovery loop preventing the unlocking of the respective recovery loop by eliminating the influence of a noise peak to the recovery process.

2. RDS decoder according to claim 1, **characterized in that** said at least one recovery loop is a carrier recovery loop and the influence of a noise peak is eliminated by blanking the output signal of a phase detector (3) within the carrier recovery loop during the noise peak.

3. RDS decoder according to claim 2, **characterized in that** said output signal of the phase detector (3) is set to zero to blank it.

4. RDS decoder according to anyone of the preceding claims, **characterized in that** said at least one recovery loop is a time recovery loop and the influence of a noise peak is eliminated by blanking the time error detected within the time recovery loop during the noise peak.

5. RDS decoder according to claim 4, **characterized in that** said time error is set to zero to blank it.

6. RDS decoder according to anyone of the preceding claims, **characterized in that** said noise peak is detected by a threshold function within the respective recovery loop.

7. RDS decoder according to anyone of the preceding claims, **characterized in that** said noise peak is detected by a noise peak detector of an audio noise blanker included in the receiver which hosts the RDS decoder.

8. RDS decoder according to anyone of the preceding claims, **characterized in that** said noise peak is detected based on the noise in the in-quadrature component of a stereo-difference signal of a reception signal including said RDS signal.

9. Method to decode and/or demodulate a RDS signal, **characterized by** preventing the unlocking of at least one recovery loop to recover signal parts of or relations within a received RDS signal by eliminating the influence of a noise peak to the respective recovery process.

10. Method according to claim 9, **characterized in that** said at least one recovery loop is a carrier recovery loop and the influence of a noise peak is eliminated by blanking the output signal of a phase detector (3) within the carrier recovery loop during the noise peak.

11. Method according to claim 10, **characterized in that** said output signal of the phase detector (3) is set to zero to blank it.

12. Method according to anyone of the preceding claims 9 to 11, **characterized in that** said at least one recovery loop is a time recovery loop and the influence of a noise peak is eliminated by blanking the time error detected within the time recovery loop during the noise peak.

13. Method according to claim 12, **characterized in that** said time error is set to zero to blank it.

14. Method according to anyone of the preceding claims 9 to 13, **characterized in that** said noise peak is detected by a threshold function within the respective recovery loop.

15. Method according to anyone of the preceding claims 9 to 14, **characterized in that** said noise peak is detected by a a noise peak detector of an audio noise blanker included in the receiver which hosts the RDS decoder.

16. Method according to anyone of the preceding claims 9 to 15, **characterized in that** said noise peak is detected based on the noise in the in-quadrature component of a stereo-difference signal of a reception signal including said RDS signal.
